(19) Europäisches Patentamt

European Patent Office

Office européen des brevets

(11) EP 0 553 543 B1

## (12) EUROPEAN PATENT SPECIFICATION

(45) Date of publication and mention
of the grant of the patent:
**29.12.1997 Bulletin 1997/52**

(51) Int Cl.6: **G03F 1/14**, G03F 7/20

(21) Application number: **92309267.0**

(22) Date of filing: **12.10.1992**

(54) **Phase shift mask and method for forming resist pattern using said mask**

Phasenverschiebungsmaske und Verfahren zur Erzeugung eines Fotolackmusters unter Verwendung dieser Maske

Masque à décalage de phase et méthode pour former un motif dans une photoréserve en utilisant ce masque

(84) Designated Contracting States:
**DE FR GB**

(30) Priority: **31.01.1992 JP 46237/92**

(43) Date of publication of application:
**04.08.1993 Bulletin 1993/31**

(73) Proprietor: **MITSUBISHI DENKI KABUSHIKI KAISHA**
**Tokyo (JP)**

(72) Inventor: **Nakatani, Mitsunori,**
**c/o Mitsubishi Denki K.K.**
**Itami-shi, Hyogo-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
| | |
|---|---|
| **EP-A- 0 395 425** | **EP-A- 0 401 795** |
| **EP-A- 0 437 376** | **EP-A- 0 453 310** |
| **EP-A- 0 461 778** | **EP-A- 0 464 492** |
| **EP-A- 0 493 963** | **DE-A- 4 215 210** |

• **PATENT ABSTRACTS OF JAPAN vol. 16, no. 409 (P-1412) 28 August 1992 & JP-A-41 39 450**

## Description

The present invention relates to a method for forming a resist pattern and, more particularly, to a method for forming a resist pattern using a phase shift mask. It also relates to a phase shift mask.

As a semiconductor device is highly integrated, a technique capable of forming a fine resist pattern with high precision has been vigorously studied in a field of photolithography technique using projecting exposure. For example, a technique capable of forming a pattern of a level of 0.3 micron or less on a substrate is required in a semiconductor element which operates at a level of several tens of GHz. However, since the choice of resist material suitable as a mask for etching is limited, light having a wavelength of 248 nm or more has to be used. In this respect, a pattern having feature dimensions the same as that of a wavelength of light is generally formed as limitation.

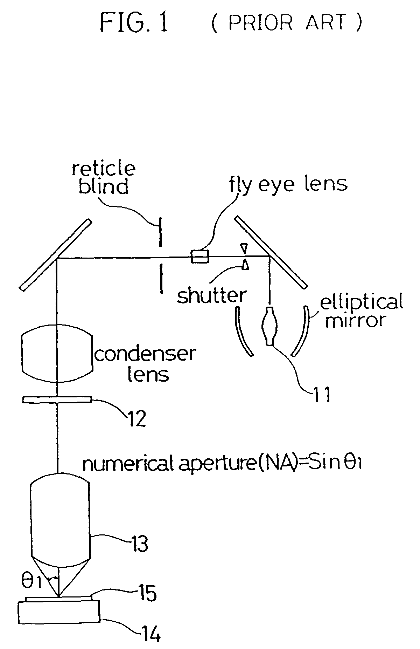

Fig. 1 is a view showing a reduced projecting exposure apparatus which is generally used for such pattern formation. In the reduced projecting exposure apparatus, a wafer 15, on which a resist having a predetermined thickness is formed, is put on a wafer stage 14 and light from an extra-high pressure mercury lamp as a light source passes through a photomask on which a predetermined mask pattern is formed, that is, a reticle 12 and then it is applied to the resist on the wafer 15 through a reduced projection lens 13. In addition, $\theta_1$ designates an angle formed by an optical axis of the projection lens 13 and a line formed by connecting an intersecting point of the optical axis and the wafer to a radius of an outgoing pupil of the projection lens 13.

In general, limit of resolution (R) of the reduced projecting exposure apparatus is represented by numerical aperture ($NA = \sin\theta_1$) of the projection lens and a wavelength ($\lambda$) of exposed light as shown in the following equation (1), where $k_1$ is a constant indicating resist performance which is 0.612 in a case of a spherical projection lens according to a theory by Rayleigh.

$$R = k_1 \lambda / NA \qquad (1)$$

In addition, when the resist pattern is actually formed, depth of focus (DOF) shown in the following equation (2) is necessary to fit for a curve or a step difference of the substrate. The DOF is generally set to 1.5 μm or more. In the equation (2), $k_2$ is a constant.

$$DOF = k_2 \lambda / (NA)^2 \qquad (2)$$

Meanwhile, it is thought that $\lambda$ may be decreased or NA may be increased according to the equation (1) in order to form a fine exposure pattern by the reduced projecting exposure apparatus. However, when the $\lambda$ is decreased, it becomes very difficult to make a lens and when the NA is increased, the DOF is reduced. Thus, there is a limit to form the fine resist pattern in respect of the exposure apparatus in addition to the resist material and it is difficult to actually form a fine pattern having feature dimensions the same as a wavelength of light or less.

As described above, recently, a method for forming a resist pattern using a phase shift mask has been proposed as a method capable of forming a fine resist pattern without being restricted by the resist material and the exposure apparatus.

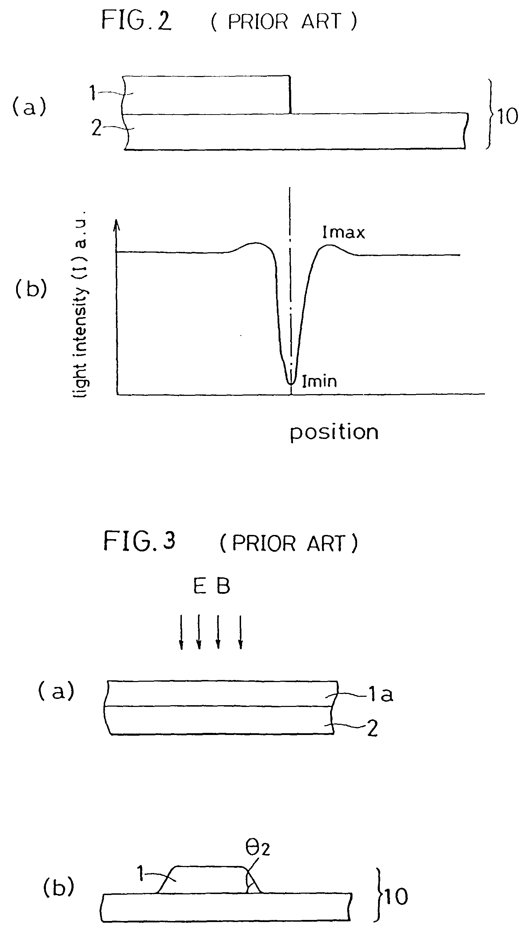

Figs. 2(a) and 2(b) are views showing a structure and a principle of the phase shift mask, in which Fig. 2 (a) is a sectional schematic view showing the structure of the phase shift mask and Fig. 2(b) is a graph showing a light intensity distribution on a surface orthogonal to an optical axis of a lens in a case where coherent light is applied to the phase shift mask shown in Fig. 2(a) and the diffracted light is focused by the lens. Referring to these figures, reference numeral 10 designates a phase shift mask which comprises a quartz substrate 2 and a phase shifter 1. In addition, in Fig. 2(b), a part where the light intensity is nearly 0 corresponds to an edge of the shifter 1.

Next, a method for forming a resist patter using the phase shift mask will be described hereinafter.

The phase shift mask 10 is used as a reticle. When light from a light source is applied to a wafer, on which a resist is applied, by the reduced projection exposure apparatus shown in Fig. 1, the light from the light source is diffracted by an edge of the phase shifter 1 comprising a wide resist towards a lower part of the phase shifter 1. Thus, a region in which a light intensity is lowered is formed only just under the edge of the phase shifter 1. Then, the transmitted light having the light intensity distribution shown in Fig. 2(b) is applied to the wafer on which the resist is applied. Then, the resist on the wafer is subjected to pattern exposure and normal developing processing is executed thereto. As a result, a fine resist pattern of a level which is a half of the wavelength of the light can be formed. In addition, when a negative type resist is used as the resist on the wafer, an opening pattern is formed just under the edge of the phase shift mask. Alternatively, when a positive type resist is used, the resist just under the edge of the phase shift mask is left on the wafer and a resist pattern in the form of a line is formed on the wafer.

Figs. 3(a) and 3(b) are sectional views showing manufacturing steps of the phase shift mask. In these figures, the same references as those in Figs. 2(a) and 2(b) designate the same or corresponding parts and reference numeral 1a designates a resist for a negative type electron beam (referred to as an EB hereinafter) such as chloromethyl styrene. More specifically, as shown in Fig. 3(a), the resist 1a for the negative type EB is applied onto the quartz substrate 2 and an EB exposure and developing processing are normally performed. Then, as shown in Fig. 3(b), the resist la at a region exposed is left on the substrate 2 and then the phase shift mask 10 shown in Fig. 2(a) can be provided.

According to the conventional method for forming a resist pattern, the phase shift mask is used as a reticle and a fine exposure pattern is applied to a resist and then the resist is developed. As a result, a fine resist pattern having feature dimensions equal to or less than the wavelength of light can be formed.

However, in the conventional resist pattern forming method using a phase shift mask, while a fine resist pattern can be formed, an edge angle $\theta_2$ of the phase shifter 1 varies in a step of manufacturing the phase shift mask as shown in Fig. 3. Therefore, a light intensity distribution of the exposure pattern obtained through the phase shift mask 10 shown in Fig. 2 also varies, so that a contrast of the light intensity in the light intensity distribution cannot be constant. Thus, in order to obtain a fine resist pattern having a predetermined width, an amount of development of the resist has to be controlled by changing developing conditions such as a developing time each time in the step of developing the resist after the exposure pattern is applied. However, since this process is very troublesome and cannot be performed with high precision, dimensions of the resist pattern still vary, so that it is very difficult to form the resist pattern having a predetermined width on a high yield with ease and high reproductivity. Especially, when the contrast of the light intensity in the exposure pattern is reduced, reactivity against developing of the resist is reduced. Therefore, if an amount of development of the resist is increased by increasing the developing time, a difference of the amount of the development between an upper layer and a lower layer of the resist is increased. For example, when an opening pattern is formed on the negative type resist, the opening becomes overhanged shape and the dimensional precision of the pattern is lowered. When thus formed resist pattern is used in the processing of the wafer thereafter, processing dimensions of the apparatus vary and characteristics of the apparatus could be deteriorated.

A method of forming a resist pattern, as set out in the preamble of claim 1 appended, is disclosed in EP-A-0401795. As disclosed therein, however, and as shown in figure 11(a) of the drawings thereof, there is provided a phase shift mask comprising, on a transparent substrate, a pair of spaced apart light shield film members having a phase shifter member provided in the space therebetween. This phase shifter member is one that has been patterned photolithographically and overlaps the end regions of the adjacent light shield film members each side of the filled space aforementioned. Also disclosed, with reference to figures 8(a) to 8(c) of the drawings thereof, are phase shift masks having a central portion of light shield film and side members of phase-shift film. The latter phase-shift film may overlap the whole, or may overlap edge portions, of the central light shield film (figs. 8(b), (c)) or may merely abut and not overlap the light-shield film.

A phase shift mask, similar in construction to that of figure 8(c) just mentioned, is also disclosed in EP-A-0395425 with reference to figure 19 thereof.

EP-A-0464492 comments on the manufacture of the phase-shift masks just mentioned and states that it is a problem since two photolithographic pattern defining exposures are required in preparing the mask. The exposure procedure is complicated, since very strict alignment is necessary for these two exposures. This reference provides, instead, a phase shift mask having phase shift members but no light shield film parts.

The present invention provides a further alternative.

The present invention, as defined by the appended claims, is intended to provide a method for forming a fine resist pattern having a width equal to or less than a wavelength of light with ease and high reproductivity and also with high precision.

Herein, the fine resist pattern in the following description means a resist pattern having feature dimensions equal to or less than a wavelength of light.

Other features and advantages of the present invention will become apparent from the detailed description given hereinafter; it should be understood, however that the detailed description and specific embodiment are given by way of illustration only, since various changes and modifications within the scope of the invention will become apparent to those skilled in the art from this detailed description.

In a method for forming a resist pattern, as defined in the appended claims, there is provided a light shielding film which, due to its width, cannot be resolved as the exposure pattern in itself on a side wall of the edge of the phase shifter. Therefore, it is possible to control, by a width of this light shielding film, the width of the a dark part of the exposure pattern whose image is formed by the projection lens, that is, the width of the region in which the light intensity is reduced to a constant level or below in the light intensity distribution. As a result, the dimensional width of the resist pattern provided in the step of exposure can be controlled and then a fine resist pattern having a desired width can be formed with high precision and high reproductivity under constant developing conditions.

In the accompanying drawings:

Fig. 1 is a view showing a structure of a reduced projecting exposure apparatus;
Figs. 2(a) and 2(b) are views showing a structure of a phase shift mask and a function thereof;
Figs. 3(a) and 3(b) are views showing an example of the steps of manufacturing a phase shift mask;
Figs. 4(a) and 4(b) are views showing a structure of a phase shift mask used in a method for forming a resist pattern in accordance with a second embodiment of the present invention and an exposure pattern (light intensity distribution) obtained by the phase shift mask;

Fig. 5 is a graph showing the relation between a width W of a light shielding film and a film thickness of a chrome film at an initial stage when the light shielding film formed of chrome is manufactured in the phase shift mask shown in Fig. 4(a); and

Figs. 6(a) - 6(d) are sectional views showing steps of forming a resist pattern on a wafer using the phase shift mask shown in Fig. 1.

An embodiment of the present invention will be described with reference to the drawings hereinafter.

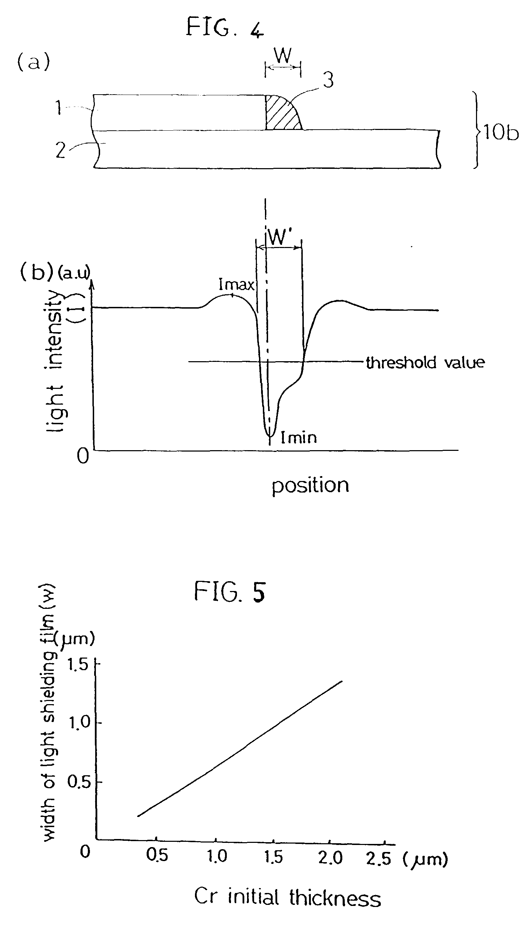

Fig. 4(a) is a schematic sectional view showing a structure of a phase shift mask which is used in accordance with a preferred embodiment of the present invention and Fig. 4(b) is a view showing a light intensity distribution on a surface orthogonal to a lens optical axis, which is obtained by applying coherent light to the phase shift mask shown in Fig. 4(a) and forming an image by focusing diffracted light through a lens. In fig. 4(a), reference numeral 1 designates a phase shifter, reference numeral 2 designates a quartz substrate, reference numeral 3 designates a light shielding film formed of chrome, reference character W designates a width of the light shielding film, and reference numeral 10b designates a phase shift mask. In fig. 4(b), reference character W' designates a width of a transfer pattern in a constant light intensity (threshold value) shown by a dotted line in the figure. The light shielding film formed of chrome is not resolved as a pattern in itself due to its width. In this figure, a width of a dark part of the exposure pattern (light intensity distribution) obtained by the phase shifter 1 can be determined corresponding to the width W of the light shielding film 3 provided on a side wall of the phase shifter 1, and the width W corresponds to the pattern width W' transferred to the resist when the resist is developed under constant developing conditions.

In addition, the phase shift mask is provided by forming the phase shifter 1 on the quartz substrate 2 in the same manner as shown in Fig. 3, then forming a chrome film by depositing chrome on the whole surface by sputtering and then leaving the chrome film having a predetermined width on the side wall of the phase shifter 1 by a normal etch back method. Fig. 5 is a view showing the relation between a film thickness of the chrome film at an initial stage and the width W of the light shielding film 3 obtained by etch back in the above steps. As can be seen from Fig. 5, the width W of the light shielding film 3 is determined by the film thickness of the chrome film at the initial stage.

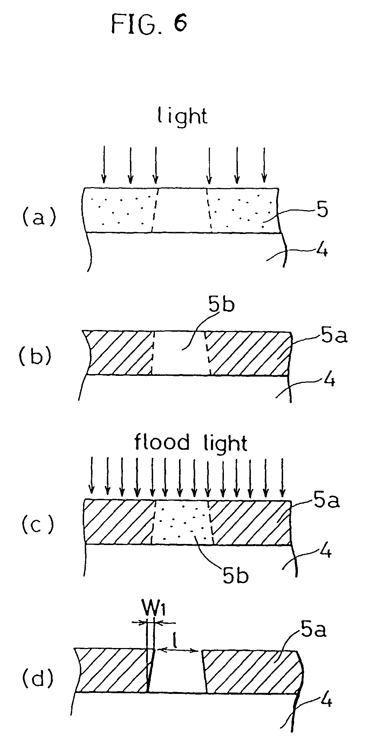

Figs. 6(a) - 6(d) are sectional views showing steps of forming a resist pattern on a wafer using the phase shift mask 10a. In these figures, reference numeral 4 designates a GaAs substrate, reference numeral 5 designates a resist, reference numeral 5a designates a crosslinking region, and reference numeral 5b designates a non-crosslinking region. The resist 5 is a negative type resist in which an exposed part is once crosslinked and made negative by heating.

Next, the steps of forming the resist pattern will be described.

First, referring to Fig. 6(a), the GaAs substrate 4 onto which the resist 5 having a predetermined thickness is applied is irradiated with an exposure pattern by a reduced projecting exposure apparatus in which the phase shift mask 10a is used as a reticle. Light from the light source is diffracted by the light shielding film 3 on the side of the edge of the phase shifter 1 and a non-crosslinking region having a width W' between the crosslinking regions is formed on the resist corresponding to the width W of the light shielding film 3.

In addition, since light is diffracted by the light shielding film 3 in the phase shift mask 10b, a dark part in which the light intensity is reduced can be surely formed, so that such problem that the contrast of the light intensity in the light intensity distribution of the exposure pattern is lowered can be solved.

Then, referring to Fig. 6(b), the crosslinking region 5a and the non-crosslinking region 5b corresponding to an exposed region and a non-exposed region, respectively, are formed on the resist 5 by heating. Then, referring to Fig. 6(c), flood exposure is performed onto the regions and then the regions are developed using predetermined alkaline developer. Then, referring to Fig. 6 (d), an opening having a predetermined width $\ell$ is formed in the resist 5.

In the step of forming the resist pattern for this embodiment of the present invention, since there is provided on a side wall of the phase shifter 1 a light shielding film 3 formed of chrome and having a width which cannot be resolved as a pattern in itself, there can be formed a light intensity distribution of the exposure pattern having a region with a constant width in which the light intensity is reduced to a constant level or less, corresponding to the width of the light shielding film 3. As a result, the width of the resist pattern provided in the exposure processing can be controlled by the width of the light shielding film 3 and then a fine resist pattern having a predetermined width can be formed with high reproductivity under the constant developing conditions without changing a developing time to adjust an amount of development. In addition, since the contrast of the light intensity in the light intensity distribution of the exposure pattern can be prevented from being lowered, the resist pattern is provided with high precision.

Although chrome is used as the light shielding film 3 in the above embodiment of the present invention, the same effect can be expected by using another metal film, if it can shield light.

In addition, since there is provided a light shielding film having a width which cannot be resolved as an exposure pattern in itself on the side wall of the phase shifter of the phase shift mask, a region in which the light intensity is reduced from the constant level can be formed corresponding to the width of the light shielding film in the exposure pattern whose image is formed by the projection lens. Therefore, a fine resist pattern having a predetermined width at the wavelength level of light or less can be formed with high dimensional precision and high reproductivity under the constant developing conditions. As a result, a semiconductor device of high performance in which fine processing is performed can be manufactured with a high yield.

## Claims

1. A method of forming a resist pattern comprising:

   irradiating, with light from a light source (11) to expose a resist film on a wafer (15), a phase shift mask (10a), in which a phase shifter (1) is provided on a transparent substrate (2) and a light shield film (3) is provided on a side wall of the phase shifter (1), which light shield film (3), due to its width, is not resolvable in itself as a pattern on said resist film on said wafer (15); the light being diffracted by an edge of the phase shifter (1); forming an image by focusing the diffracted light by a lens (13), thereby to generate an exposure pattern having a region in which the light intensity is reduced corresponding to the edge; applying the exposure pattern to the resist film on the wafer (15); developing the resist film to form a resist pattern corresponding to a light intensity distribution of the exposure pattern; which method is characterised in that: said light shield film (3) is a sidewall film abutting the side wall of said phase shifter (1) and which accordingly is not overlapped by said phase shifter (1), is aligned at one end to the side wall of said phase shifter (1) and is free at its other end remote from the side wall of said phase shifter (1).

2. A method according to claim 1 wherein focus depth when the exposure pattern is generated is 1.5 μm or more.

3. A method according to either preceding claim wherein the resist is a negative type resist.

4. A method according to any preceding claim including the following preparatory steps of producing said phase shift mask (12):

   forming said phase shifter (1) on said substrate (2); depositing light shielding film (3) on the surface of said phase shifter (1) and on the adjacent surface of said substrate (2); and etching back said light shielding film (3) to leave a sidewall film (3) of light shielding film material aligned to and abutting a sidewall of said phase shifter.

5. A method of manufacturing a semiconductor device comprising the method of any of the preceding claims and a step of fabricating a semiconducor device using the developed resist pattern on the wafer.

6. A phase shift mask, for use in the method of claim 1, wherein a phase shifter (1) is provided on a transparent substrate (2) and a light shield film (3) is provided on a side wall of the phase shifter (1), which light shield film (3), due to its width, is not resolvable in itself as a pattern on a resist film on a wafer (15);

   which mask is characterised in that: said light shield film (3) is a sidewall film abutting the side wall of said phase shifter (1) and which accordingly is not overlapped by said phase shifter (1), is aligned at one end to the side wall of said phase shifter (1) and is free at its other end remote from the side wall of said phase shifter (1).

## Patentansprüche

1. Ein Verfahren zum Erzeugen eines Fotolackmusters mit:

   Bestrahlen einer Phasenverschiebungsmaske (10a), in der ein Phasenschieber (1) auf einem transparenten Substrat (2) bereitgestellt ist und ein Lichtabschirmfilm (3) an einer Seitenwand des Phasenschiebers (1) bereitgestellt ist, mit Licht von einer Lichtquelle (11), um einen Fotolackfilm auf einem Wafer (15) zu belichten, wobei der Lichtabschirmfilm (3) aufgrund seiner Breite nicht in sich selbst als ein Muster auf dem Fotolackfilm auf dem Wafer (15) auflösbar ist, und wobei das Licht durch eine Kante des Phasenschiebers (1) gebeugt wird;

   Erzeugen eines Bildes durch Fokussieren des gebeugten Lichts mittels einer Linse (13), um dadurch ein Belichtungsmuster zu erzeugen, das ein Gebiet aufweist, in dem die Lichtintensität entsprechend der Kante verringert ist;

   Beaufschlagen des Fotolackfilms auf dem Wafer (15) mit dem Belichtungsmuster;

   Entwickeln des Fotolackfilms, um ein Fotolackmuster entsprechend einer Lichtintensitätsverteilung des Belichtungsmusters auszubilden;

   wobei das Verfahren dadurch gekennzeichnet ist, daß:

der Lichtabschirmfilm (3) ein Seitenwandfilm ist, der an die Seitenwand des Phasenschiebers (1) anstößt, und der dementsprechend nicht von dem Phasenschieber (1) überdeckt wird, bei einem Ende an der Seitenwand des Phasenschiebers (1) ausgerichtet ist und bei seinem anderen Ende, das entfernt von der Seitenwand des Phasenschiebers (1) liegt, frei ist.

2. Ein Verfahren nach Anspruch 1, worin die Tiefenschärfe 1,5 µm oder mehr beträgt, wenn das Belichtungsmuster erzeugt ist.

3. Ein Verfahren nach jedem vorhergehenden Anspruch, worin der Fotolack ein Fotolack vom negativen Typ ist.

4. Ein Verfahren nach einem vorhergehenden Anspruch, das die folgenden vorbereitenden Schritte des Erzeugens der Phasenverschiebungsmaske (12) umfaßt:

Ausbilden des Phasenschiebers (1) auf dem Substrat (2);

Aufbringen des Lichtabschirmfilms (3) auf der Oberfläche des Phasenschiebers (1) und auf der angrenzenden Oberfläche des Substrats (2) ; und

Rückätzen des Lichtabschirmfilms (3), um einen Seitenwandfilm (3) aus dem Material des Lichtabschirmfilms stehenzulassen, der an einer Seitenwand des Phasenschiebers ausgerichtet ist und an diese anstößt.

5. Ein Verfahren zur Herstellung einer Halbleitervorrichtung, das das Verfahren nach einem der vorhergehenden Ansprüche und einen Schritt zur Fertigung einer Halbleitervorrichtung unter Verwendung des entwickelten Fotolackmusters auf dem Wafer aufweist.

6. Eine Phasenverschiebungsmaske zur Verwendung in dem Verfahren nach Anspruch 1, worin ein Phasenschieber (1) auf einem transparenten Substrat (2) bereitgestellt ist und ein Lichtabschirmfilm (3) an einer Seitenwand des Phasenschiebers (1) bereitgestellt ist, wobei der Lichtabschirmfilm (3) aufgrund seiner Breite nicht in sich selbst als ein Muster auf einem Fotolackfilm auf einem Wafer (15) auflösbar ist;

wobei die Maske dadurch gekennzeichnet ist, daß:

der Lichtabschirmfilm (3) ein Seitenwandfilm ist, der an die Seitenwand des Phasenschiebers (1) anstößt, und der dementsprechend nicht von dem Phasenschieber (1) überdeckt wird, bei einem Ende an der Seitenwand des Phasenschiebers (1) ausgerichtet ist und bei seinem anderen Ende, das entfernt von der Seitenwand des Phasenschiebers (1) liegt, frei ist.

**Revendications**

1. Procédé pour former un motif du résist comprenant les étapes consistant à :

soumettre à une irradiation, avec de la lumière provenant d'une source de lumière (11) pour exposer un film de résist sur une plaquette (15), un masque à décalage de phase (10a), où un déphaseur (1) est prévu sur un support transparent (2) et un film à écran de lumière (3) est prévu sur une paroi latérale du déphaseur (1), ce film à écran de lumière (3), du fait de sa largeur, ne peut pas être identifié en tant que tel comme motif sur ledit film de résist sur ladite plaquette (15) ; la lumière étant diffractée par un bord du déphaseur (1) ;
former une image en focalisant la lumière diffractée par une lentille (13) en produisant ainsi un motif d'exposition ayant une région où l'intensité de la lumière est diminuée, correspondant au bord ;
appliquer un motif d'exposition au film du résist sur la plaquette (15) ;
développer le film de résist pour former un motif de résist correspondant à une distribution de l'intensité de la lumière du motif d'exposition ;
ce procédé étant caractérisé en ce que :
ledit film à écran de lumière (3) est un film de paroi latérale butant contre la paroi latérale dudit déphaseur (1) et qui par conséquent n'est pas chevauché par ledit déphaseur (1), est aligné à une extrémité avec la paroi latérale dudit déphaseur (1) et est libre à son autre extrémité éloignée de la paroi latérale dudit déphaseur (1).

2. Procédé selon la revendication 1, où la profondeur focale, lorsque le motif d'exposition est produit, est de 1,5 µm ou plus.

3. Procédé selon l'une des revendications précédentes, où le résist est un résist de type négatif.

4. Procédé selon l'une des revendications précédentes incluant les étapes préparatoires suivantes pour la production dudit masque à décalage de phase (12) :

formé ledit déphaseur (1) sur ledit support (2) ;
déposer le film à écran de lumière (3) sur la surface dudit déphaseur (1) et sur la surface adjacente dudit support (2) ; et
graver en retrait ledit film à écran de lumière (3) pour laisser un film de paroi latérale (3) du matériau de film à écran de lumière aligné avec et butant contre une paroi latérale dudit déphaseur.

5. Procédé de fabrication d'un composant à semiconducteur comprenant le procédé selon l'une des revendications précédentes et une étape de fabrication d'un composant à semiconducteur utilisant le motif développé du résist sur la plaquette.

6. Masque à décalage de phase, pour utilisation dans le procédé de la revendication 1, où un déphaseur (1) est prévu sur un support transparent (2), et un film à écran de lumière (3) est prévu sur une paroi latérale du déphaseur (1), ledit film à écran de lumière (3), du fait de sa largeur, n'est pas identifiable en tant que tel comme motif sur un film de résist sur une plaquette (15) ;

ledit masque étant caractérisé en ce que :
ledit film à écran de lumière (3) est un film de paroi latérale butant contre la paroi latérale dudit déphaseur (1) et qui, par conséquent, n'est pas chevauché par ledit déphaseur (1), est aligné à une extrémité avec la paroi latérale dudit déphaseur (1) et est libre à son autre extrémité éloignée de la paroi latérale dudit déphaseur (1).

# FIG. 1 ( PRIOR ART )

reticle
blind

fly eye lens

shutter

elliptical
mirror

11

condenser
lens

12

numerical aperture(NA)=Sin θ₁

13

θ₁

15

14

FIG. 2 ( PRIOR ART )

(a)

1

2

}10

(b)

light intensity (I) a.u.

Imax

Imin

position

FIG. 3 ( PRIOR ART )

E B

(a)

1a

2

(b)

1

θ2

}10

## FIG. 4

(a)

(b)

## FIG. 5

# FIG. 6

light

(a)

5
4

5b

(b)

5a
4

flood light

(c)

5a
4

5b

(d)

$W_1$

$l$

5a
4